# EUROPEAN PATENT APPLICATION

(11) **EP 2 538 439 A1**
(43) Date of publication of application: **26.12.2012**
(21) Application number: 10846171.6
(22) Date of filing: 30.11.2010
(51) Int. Cl.: H01L 23/13, H01L 33/62, H05K 1/09, H05K 3/24, H05K 3/28

(54) **SUBSTRATE FOR MOUNTING ELEMENT, AND METHOD FOR MANUFACTURING THE SUBSTRATE**

(30) Priority: 19.02.2010 JP 2010034717
(71) Applicant: Asahi Glass Company, Limited, Tokyo 100-8405 (JP)
(72) Inventor: NAKAYAMA, Katsuyoshi, Tokyo 100-8405 (JP)
(74) Representative: Müller-Boré & Partner Patentanwälte
(86) International application number: PCT/JP2010/071395
(87) International publication number: WO 2011/102040

(57) **Abstract**

A substrate 1 for mounting an element, comprising a low temperature co-fired ceramic substrate 2, a thick film conductor layer 3 made of a metal composed mainly of silver, which is formed on the surface of the low temperature co-fired ceramic substrate 2, a covering 4 made of a low temperature co-fired ceramic, which covers the edge portion 31 of the thick film conductor layer 3 and which is bonded to the low temperature co-fired ceramic substrate 2 on the outer side of the edge portion 31, and a plated layer 5 made of an electrically conductive metal, which is formed on the surface of the thick film conductor layer 3.

## Description

### TECHNICAL FIELD

The present invention relates to a substrate for mounting an element and its production process, particularly a substrate for mounting an element excellent in the sulfurization resistance and a production process for producing such a substrate for mounting an element.

### BACKGROUND ART

In recent years, along with a tendency to high-density mounting of electronic devices and the increase in the processing speed, a low temperature co-fired ceramic substrate (LTCC substrate) having excellent properties of a low dielectric constant and a low wiring resistance has been used. Further, as a substrate for mounting an element on which a light-emitting element such as a light-emitting diode (LED) element is to be mounted, use of a LTCC substrate has been studied.

A LTCC substrate is formed by firing at a temperature of about from 800 to 1,000°C which is lower than the firing temperature of a conventional ceramic substrate, and is prepared by overlaying a predetermined number of green sheets comprising glass and a ceramic filler such as an alumina filler or a zirconia filler and bonding them by thermal compression, followed by firing.

On the surface of such a LTCC substrate, a thick film conductor layer obtained by firing a paste composed mainly of a conductor metal of silver or copper is formed as a connection terminal (electrode). On the surface of the thick film conductor layer, in order to obtain good wire bonding properties, adhesion strength, weather resistance and the like, for example, a plated layer (nickel layer/gold plated layer) consisting of a nickel plated layer and a gold plated layer is formed. By forming such a plated layer, particularly sulfurization resistance can be improved, whereby discoloration of the thick film conductor layer by reaction with a sulfur content e.g. in the air can be suppressed (for example, Patent Documents 1 and 2).

### PRIOR ART DOCUMENTS

### PATENT DOCUMENTS

Patent Document 1: JP-Y-2-36278
Patent Document 2: JP-A-2002-314230

### DISCLOSURE OF INVENTION

### TECHNICAL PROBLEM

By the way, the thickness of the thick film conductor layer is usually considered to be about from 5 to 15 µm, and the thickness of the plated layer particularly the nickel plated layer formed thereon is considered to be about from 5 to 15 µm. However, it is difficult to accurately control the thickness of the nickel plated layer, and the layer may be formed unexpectedly thickly in some cases. If the nickel plated layer is formed thickly, an excessive tensile stress is applied to the thick film conductor layer, and its edge may be peeled from the LTCC substrate. In such a case, moisture in the air will infiltrate in the space between the LTCC substrate and the thick film conductor layer, and silver in the thick film conductor layer diffuses to the surface of the plated layer particularly to the gold plated layer on the outermost surface along the edge.

If the substrate for mounting an element in such a state is exposed to sulfurizing environment, silver which diffused to the gold plated layer on the outermost surface may be sulfurized, whereby the wire bonding properties, etc. may be decreased. Further, the reflectance tends to be decreased by blackening of the surface of the gold plated layer, and such a substrate is not necessarily preferred for mounting a light-emitting element or the like.

To solve the above problems, the object of the present invention is to provide a substrate for mounting an element in which peeling of the thick film conductor layer is suppressed, and which is excellent in the sulfurization resistance. Further, the object of the present invention is to provide a process for producing such a substrate for mounting an element excellent in the sulfurization resistance.

### SOLUTION TO PROBLEM

The substrate for mounting an element of the present invention comprises a low temperature co-fired ceramic substrate, a thick film conductor layer made of a metal composed mainly of silver, which is formed on the surface of the low temperature co-fired ceramic substrate, a covering made of a low temperature co-fired ceramic, which covers the edge portion of the thick film conductor layer and which is bonded to the low temperature co-fired ceramic substrate on the outer side of the edge portion, and a plated layer made of an electrically conductive metal, which is formed on the surface of the thick film conductor layer.

It is preferred that of the covering, the portion which is formed on the thick film conductor layer, is formed in a region of from 0.05 to 0.2 mm on the inside of the edge of the thick film conductor layer, and of the covering, the portion which is formed on the low temperature co-fired ceramic substrate, is formed in a region of at least 0.2 mm on the outer side of the edge of the thick film conductor layer.

It is preferred that of the covering, the portion which is formed on the thick film conductor layer, is formed in a region of from 0.03 to 0.2 mm on the inside of the edge of the thick film conductor layer, and of the covering, the portion which is formed on the low temperature co-fired ceramic substrate, is formed in a region of at least 0.2 mm on the outer side of the edge of the thick film conductor layer.

It is preferred that the covering has a height of from 0.04 to 0.2 mm from the low temperature co-fired ceramic substrate, at its portion of up to 0.05 mm on the inside of the edge of the thick film conductor layer and at its portion of up to 0.2 mm on the outer side of the edge of the thick film conductor layer.

It is preferred that the covering has a height of from 0.02 to 0.2 mm from the low temperature co-fired ceramic substrate, at its portion of up to 0.03 mm on the inside of the edge of the thick film conductor layer and at its portion of up to 0.2 mm on the outer side of the edge of the thick film conductor layer.

It is preferred that the covering is provided over the entire circumference of the edge of the thick film conductor layer, and it is preferred that the covering is made of the same material as the low temperature co-fired ceramic substrate. It is preferred that the plated layer has a double-layered structure consisting of a nickel plated layer and a gold plated layer formed thereon.

The process for producing a substrate for mounting an element of the present invention comprises forming a non-fired thick film conductor layer made of a paste of a metal composed mainly of silver, on the surface of a non-fired substrate made of a glass ceramic composition containing a glass powder and a ceramic filler, forming a non-fired covering made of a glass ceramic composition containing a glass powder and a ceramic filler, so as to extend over the edge portion of the non-fired thick film conductor layer and the non-fired substrate on the outside of the edge portion, firing the non-fired substrate on which the non-fired thick film conductor layer and the non-fired covering are formed, to produce a substrate having a thick film conductor layer and a covering, and forming a plated layer made of an electrically conductive metal on the surface of the thick film conductor layer.

It is preferred that the non-fired covering is a green sheet of a glass ceramic composition containing a glass powder and a ceramic filler.

### ADVANTAGEOUS EFFECTS OF INVENTION

According to the present invention, by forming a covering made of a low temperature co-fired ceramic so as to cover the edge portion of the thick film conductor layer and so as to be bonded to the low temperature co-fired ceramic substrate on the outer side of the edge portion, peeling of the thick film conductor layer from the low temperature co-fired ceramic substrate can be suppressed, and a substrate for mounting an element having good sulfurization resistance can be obtained.

### BRIEF DESCRIPTION OF DRAWINGS

Fig. 1 is a plan view illustrating one example of a substrate for mounting an element of the present invention.
Fig. 2 is a cross-sectional view at the line X-X of the substrate for mounting an element as shown in Fig. 1.
Fig. 3 is an enlarged cross-sectional view illustrating a part in Fig. 2 as enlarged.
Fig. 4 is an enlarged cross-sectional view illustrating a modified example of a substrate for mounting an element of the present invention.
Fig. 5 is a view illustrating a process for producing a substrate for mounting an element of the present invention.

### DESCRIPTION OF EMBODIMENTS

Now, the present invention will be described with reference to drawings.

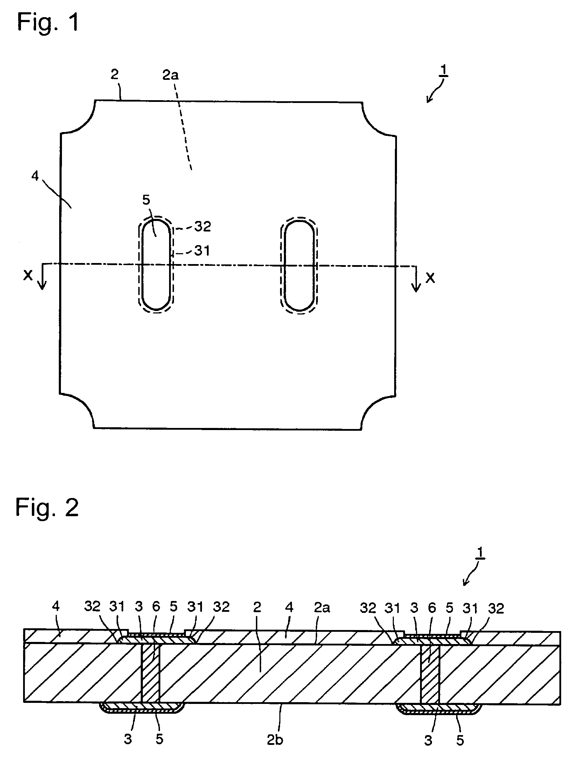

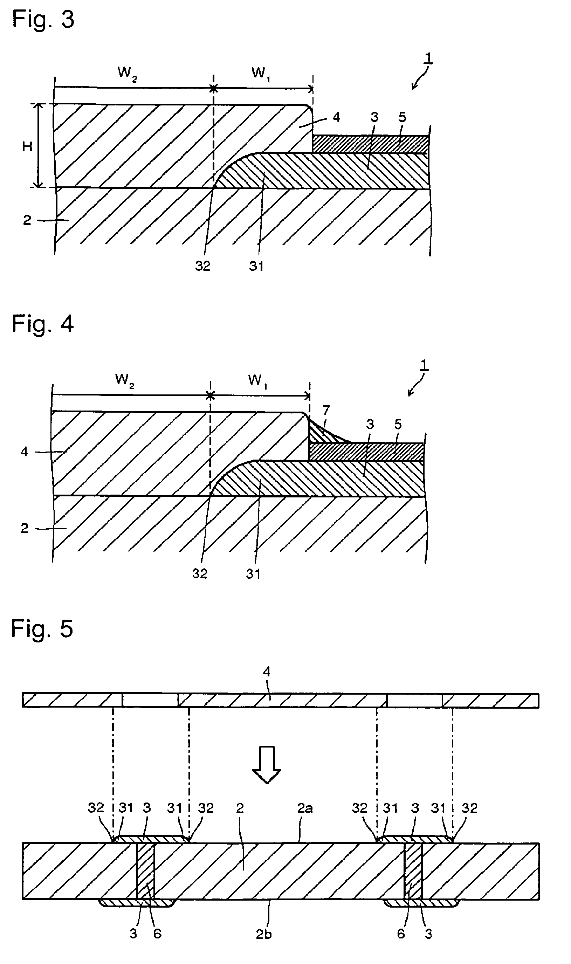

Fig. 1 is a plan view illustrating one example of a substrate 1 for mounting an element of the present invention. Fig. 2 is a cross-sectional view at the line X-X of the substrate 1 for mounting an element as shown in Fig. 1, and Fig. 3 is an enlarged cross-sectional view illustrating a part thereof as enlarged.

The substrate 1 for mounting an element of the present invention has a low temperature co-fired ceramic substrate (LTCC substrate) 2 made of a sintered product of a glass ceramic composition containing a glass powder and a ceramic filler. On one main surface of the LTCC substrate 2, a mounting surface 2a on which an element, for example, a light-emitting element such as a LED element is to be mounted is provided. The shape, the thickness, the size, etc. of the LTCC substrate 2 are not necessarily limited, and although not shown, for example, on the mounting surface 2a side of the LTCC substrate 2, a side wall such that the inside is for example circular may be provided so as to surround the mounting surface 2a.

On desired positions of the mounting surface 2a, a thick film conductor layer 3 to be a connection terminal (i.e. an electrode) to be electrically connected to an element is formed. The thick film conductor layer 3 is made of a conductor metal composed mainly of silver, and is formed by applying a paste of the conductor metal e.g. by screen printing, followed by firing, as described hereinafter. Here, the thick film conductor layer made of a conductor metal composed mainly of silver means a thick film conductor layer containing at least 90%, preferably 95% of silver.

Further, on the LTCC substrate 2, a covering 4 made of a low temperature co-fired ceramic to cover an edge portion 31 of the thick film conductor layer 3 and to be bonded to the LTCC substrate 2 on the outer side of the edge portion 31, is formed. On a portion not covered with the covering 4 on the surface of the thick film conductor layer 3, specifically, on the inside of the covering 4, a plated layer 5 comprising an electrically conductive metal is formed to cover the thick film conductor layer 3 without any space. The plated layer 5 is constituted, for example, by a nickel plated layer covering the surface of the thick film conductor layer 3 and a gold plated layer covering the nickel plated layer, although not shown.

On the other hand, on a non-mounting surface 2b on the opposite side from the mounting surface 2a, a thick film conductor layer 3 to be a connection electrode (i.e. an electrode) for external connection is formed, and on the thick film conductor layer 3, a plated layer 5 is formed so as to cover the entire surface of the thick film conductor layer 3 without any space. Further, in the interior of the LTCC substrate 2, a through hole conductor 6 to electrically connect a connection terminal on the mounting surface 2a and a connection terminal on the non-mounting surface 2b is provided. The thick film conductor layer 3 and the plated layer 5 on the non-mounting surface 2b may be made of the same materials as the thick film conductor layer 3 and the plated layer 5 formed on the mounting surface 2a, respectively. Further, the through hole conductor 6 may be made of the same material as the thick film conductor layer 3 formed on the mounting surface 2a and the non-mounting surface 2b.

The substrate 1 for mounting an element of the present invention is characterized by having a covering 4 made of a low temperature co-fired ceramic to cover the edge portion 31 of the thick film conductor layer 3 and to be bonded to the LTCC substrate 2 on the outside of the edge portion 31. The covering 4 should be provided at least on the edge portion 31 of the thick film conductor layer 3 provided on the mounting surface 2a.

According to such a covering 4, the thick film conductor layer 3 can be pressed against the LTCC substrate 2, and peeling of the thick film conductor layer 3 from the LTCC substrate 2 can effectively be suppressed even in a case where the nickel plated layer 5 particularly a nickel plated layer is formed unexpectedly thickly and an excessive tensile stress is applied to the thick film conductor layer 3.

By suppressing peeling of the thick film conductor layer 3 from the LTCC substrate 2 in such a manner, diffusion of silver in the thick film conductor layer to the surface of the plated layer 5 can be suppressed, and sulfurization in sulfurizing environment can be suppressed. As a result, a substrate having good wire bonding properties, etc., and having a good reflectance required when a light-emitting element is mounted, can be obtained. Further, such a covering 4 can be made of the same material as the LTCC substrate 2, and formation is possible by firing at the same time as firing of the LTCC substrate 2 and the thick film conductor layer 3.

Such a covering 4 is not necessarily limited so long as it is made of a low temperature co-fired ceramic i.e. a sintered product of a glass ceramic composition containing a glass powder and a ceramic filler, however, one having a difference in the thermal expansion coefficient with the LTCC substrate 2 of at most 0.5 ppm/K is preferred. If the difference in the thermal expansion coefficient with the LTCC substrate 2 exceeds 0.5 ppm/K, cracks, etc. may form on the bonding portion between the LTCC substrate 2 and the covering 4. The thermal expansion coefficients of the LTCC substrate 2 and the covering 4 can be measured by a thermo -mechanical analyzer (TMA).

The covering 4 should cover at least the edge portion 31 of the thick film conductor layer 3 and be bonded to the LTCC substrate 2 on the outer side of the edge portion 31, however, the portion covering the edge portion 31 of the thick film conductor layer 3 is preferably formed in a region of at least 0.03 mm, more preferably at least 0.05 mm, on the inside (the right side in Fig. 3) of the edge 32 of the thick film conductor layer 3. Further, the portion covering the edge portion 31 of the thick film conductor layer 3 is preferably formed in a region of at most 0.2 mm on the inside of the edge 32 of the thick film conductor layer 3. That is, W₁ in Fig. 3 is preferably from 0.03 to 0.2 mm. Particularly, W₁ is more preferably from 0.05 to 0.2 mm.

When the region (W₁) which is the portion covering the thick film conductor layer 3 is at least 0.03 mm, particularly at least 0.05 mm, the size is sufficient to press the thick film conductor layer 3, and peeling of the thick film conductor layer 3 from the LTCC substrate 2 can effectively be suppressed. It is preferably at least 0.04 mm, more preferably at least 0.05 mm. Further, a region (W₁) of 0.2 mm is sufficient to suppress peeling of the thick film conductor layer 3 from the LTCC substrate 2, and if it is larger than 0.2 mm, a region for wire bonding may rather be decreased. It is more preferably at most 0.18 mm, further preferably at most 0.16 mm.

On the other hand, of the covering 4, the portion to be bonded to the LTCC substrate 2 is preferably formed in a region of at least 0.2 mm on the outer side (left side in Fig. 3) of the edge 32 of the thick film conductor layer 3. That is, W₂ in Fig. 3 is preferably at least 0.2 mm.

When the region (W₂) which is the portion bonded to the LTCC substrate 2 is at least 0.2 mm, bonding between the LTCC substrate 2 and the covering 4 will be sufficient and as a result, peeling of the thick film conductor layer 3 from the LTCC substrate can effectively be suppressed. The portion bonded to the LTCC substrate 2 is not particularly limited so long as it is formed in a region of at least 0.2 mm on the outer side of the edge 32 of the thick film conductor layer 3 and for example, the covering 4 may be formed to the edge of the LTCC substrate 2 as shown in Figs. 1 and 2, i.e. on the entire mounting surface 2a excluding the thick film conductor layer 3.

Further, when the covering 4 is formed on the above region, the height (H) of the covering 4 from the LTCC substrate 2 is preferably from 0.02 to 0.2 mm, particularly preferably from 0.04 to 0.2 mm, at its portion of up to 0.03 mm on the inside of the edge 32 of the thick film conductor layer 3 (i.e. a portion from the edge 32 to W₁=0.03 mm) and at its portion of up to 0.2 mm on the outer side of the edge 32 of the thick film conductor layer 3 (i.e. a portion from the edge 32 to W₂=0.2 mm).

When the height (H) of the covering 4 is at least 0.02, particularly at least 0.04 mm, the thickness of the covering 4 on the thick film conductor layer 3 is sufficient, and peeling of the thick film conductor layer 3 from the LTCC substrate 2 can effectively be suppressed. The height is more preferably at least 0.04 mm, further preferably at least 0.06 mm. Further, a height (H) of the covering 4 of 0.2 mm is sufficient to suppress peeling of the thick film conductor layer 3 from the LTCC substrate 2, and if the height exceeds 0.2 mm, when a light-emitting element or the like is mounted for example, a bonding wire to connect the light-emitting element or the like to the connection terminal is likely to be caught by the upper portion of the covering 4. It is preferably at most 0.18 mm, more preferably 0.16 mm. The height (H) of the covering 4 may be different between the inside and the outside, however, it is preferably within a range of the above height (H) on the above portion.

Such a covering 4 may be provided over the entire circumference of the edge portion 31 of the thick film conductor layer 3 and over the entire mounting surface 2a on the outer side of the thick film conductor layer 3 as shown in Fig. 1 for example, but it is not necessarily provided over the entire mounting surface 2a, and although not shown, it may be provided in a ring-form only in the vicinity of the edge portion 31 of the thick film conductor layer 3 and the outer side thereof for example. In such a case, the region (W₁) and the region (W₂) of the covering 4 are not necessarily constant over the entire circumference of the thick film conductor layer 3, but they are preferably within the above ranges of region (W₁) and the region (W₂) at any portion.

In the above-mentioned substrate 1 for mounting an element of the present invention, as shown in Fig. 4 for example, a resin layer 7 may be formed to fill a corner formed by the inside side surface of the covering 4 and the upper surface of the plated layer 5. That is, the plated layer 5 is formed after formation of the thick film conductor layer 3 and the covering 4, and is not necessarily closely contacted to the inside side surface of the covering 4 in some cases. By infiltration of moisture in the air to the space between the covering 4 and the plated layer 5, silver in the thick film conductor layer 3 may diffuse to the surface of the plated layer 5.

Accordingly, by forming the resin layer 7 at a corner formed by the covering 4 and the plated layer 5, infiltration of moisture to the space between them can be suppressed, and diffusion of silver can effectively be suppressed. The resin constituting the resin layer 7 may be either of a thermoplastic resin and a thermosetting resin. Usually a thermosetting resin is preferred, and particularly an epoxy resin is preferred, which can effectively suppress infiltration of moisture.

Now, the process for producing a substrate 1 for mounting an element of the present invention will be described.

In the following description, members to be used for production of the substrate 1 for mounting an element, layers to be formed, etc. will be described with reference to the same symbols as members of the substrate 1 for mounting an element which the members finally constitute.

The process for producing a substrate 1 for mounting an element of the present invention comprises forming a non-fired thick film conductor layer 3 made of a paste of a metal composed mainly of silver, on the surface of a non-fired LTCC substrate 2 made of a glass ceramic composition containing a glass powder and a ceramic filler (non-fired substrate production step), forming a non-fired covering 4 made of a glass ceramic composition containing a glass powder and a ceramic filler, so as to extend over the edge portion 31 of the non-fired thick film conductor layer 3 and the non-fired LTCC substrate 2 on the outer side of the edge portion 31 (non-fired covering forming step), firing the non-fired LTCC substrate 2 on which the non-fired thick film conductor layer 3 and the non-fired covering 4 are formed, to produce a LTCC substrate 2 having a thick film conductor layer 3 and a covering 4 (firing step), and forming a plated layer 5 made of an electrically conductive metal on the surface of the thick film conductor layer 3 (plating step). More specifically, it is preferred to produce the substrate 1 for mounting an element according to the present invention by carrying out the above respective steps of the non-fired substrate production step, the non-fired covering forming step, the firing step and the plating step in this order.

In the non-fired substrate production step, first, a green sheet for substrate to be the non-fired LTCC substrate 2 is formed. The green sheet for substrate can be produced by adding a binder and as the case requires, a plasticizer, a solvent, etc. to a glass ceramic composition containing a glass powder and a ceramic filler to prepare a slurry, and forming the slurry into a sheet form e.g. by a doctor blade method, followed by drying.

The glass powder is not particularly limited, but is preferably one having a glass transition point (Tg) of from 550 to 700°C. If the glass transition point (Tg) is less than 550°C, the after-mentioned binder burn out may be difficult, and if it exceeds 700°C, the shrinkage starting temperature tends to be high, whereby the dimensional accuracy may be decreased.

As the glass powder, for example, a glass powder having a glass composition comprising, as represented by mol% as calculated as the following oxides, from 57 to 65 mol% of SiO₂, from 13 to 18 mol% of B₂O₃, from 9 to 23 mol% of CaO and from 3 to 8 mol% of Al₂O₃, containing at least one selected from K₂O and Na₂O and comprising from 0.5 to 6 mol% of K₂O Na₂O, or K₂O and Na₂O is used. The 50% particle size (D₅₀) of the glass powder is preferably from 0.5 to 2 µm. If D₅₀ of the glass powder is less than 0.5 µm, the glass powder is likely to cohere, whereby the handling tends to be difficult, and it tends to be difficult to uniformly disperse it. On the other hand, if D₅₀ exceeds 2 µm, the glass softening temperature is likely to rise, or the sintering is likely to be inadequate. In this specification, the particle size is a value measured by a laser diffraction scattering method.

As the ceramic filler, one used for the production of a LTCC substrate heretofore may be used, and for example, an alumina powder, a zirconia powder or a powder mixture of an alumina powder with a zirconia powder may suitably be used. D₅₀ of the ceramic filler is preferably from 0.5 to 4 µm. In addition to the above, there is a white ceramic filler, but its use is preferably avoided since it may cause drawbacks on a substrate for mounting a light-emitting element. Such drawbacks may, for example, be a decrease in the light reflectance, a decrease in the strength, a decrease in the sintering property, and an increase in the difference in the thermal expansion coefficient with a mounting substrate (for example, a glass epoxy substrate) due to a decrease in the thermal expansion coefficient.

Such a glass powder and a ceramic filler are blended and mixed, for example, so that the glass powder would be from 30 to 50 mass%, and the ceramic filler would be from 50 to 70 mass%, to obtain a glass ceramic composition. To this glass ceramic composition, a binder and as the case requires, a plasticizer, a solvent, etc. are added to obtain a slurry. In a case where the ceramic filler is a powder mixture of an alumina powder with a zirconia powder, preferred is a mixture having a mixing ratio of alumina powder: zirconia powder of from 90:10 to 50:50 by the mass ratio, particularly preferably from 70:30 to 50:50.

As the binder, for example, polyvinyl butyral or an acrylic resin may be suitably used. As the plasticizer, for example, dibutyl phthalate, dioctyl phthalate or butyl benzyl phthalate may be employed. Further, as the solvent, an aromatic or alcohol organic solvent such as toluene, xylene or butanol may be used. Further, a dispersing agent or a leveling agent may be used in combination.

The green sheet for substrate thus produced is cut into a square having predetermined dimensions by using a cutting die or a punching machine, and via holes for interlayer connection are formed by punching to obtain a non-fired LTCC substrate 2. On the surface of the non-fired LTCC substrate 2, a paste of a conductor metal is formed by a method such as screen printing to form a non-fired thick film conductor layer 3. In the via holes for interlayer connection also, a non-fired through hole conductor 6 is formed by filling with a paste of a conductor metal.

The paste of a conductor metal may, for example, be a metal powder containing silver as the main component, specifically, one having a vehicle such as ethyl cellulose and as the case requires, the solvent, etc. added to a metal powder containing at least 50 mass%, more preferably at least 90%, further preferably at least 95% of silver, to form a paste. The metal powder is suitably a silver powder, a powder mixture of silver with palladium, a powder mixture of silver with platinum, or a silver/palladium alloy powder or a silver/platinum alloy powder. In the case of the powder mixture or the alloy powder of silver with palladium, the addition amount of palladium is preferably at most 10%, more preferably at most 5%. If it exceeds 10%, the sintering property will significantly be decreased, and the adhesion to the LTCC substrate 2 will be decreased. In the case of the powder mixture or the alloy powder of silver with platinum, the addition amount of platinum is preferably at most 3%, more preferably at most 1%. If it exceeds 3%, the sintering property will significantly be decreased, and the adhesion to the LTCC substrate 2 will be decreased. Further, it is preferably at most 3% also from the economical viewpoint since platinum is expensive as compared with silver. The metal powder is suitably a silver powder, a powder mixture of silver with palladium, a powder mixture of silver with platinum, or the like. In the present invention, since the adhesive force between the conductor metal and the LTCC substrate 2 can sufficiently be secured by the glass component contained in the LTCC substrate 2 and in order not to increase the electrical resistance (resistance) of the conductor metal, it is preferred not to blend glass frit with the paste of a conductor metal.

In the non-fired covering forming step, first, a green sheet for covering to be a non-fired covering 4 is produced. The green sheet for covering may basically be produced in the same manner as the green sheet for substrate. The green sheet for covering is cut by using a cutting die or a punching machine to obtain a non-fired covering 4. The region (W₁) and the region (W₂) of the covering 4 to be finally obtained can be adjusted by adjusting the shape at the time of cutting. Further, the height (H) of the covering 4 to be finally obtained can be adjusted by adjusting the thickness of the green sheet for covering.

And, the non-fired covering 4 is overlaid on the non-fired LTCC substrate 2, and they are entirely pressurized with heating for example, whereby the non-fired covering 4 is closely attached to the non-fired LTCC substrate 2 to form a non-fired laminate. On that occasion, as shown in Fig. 5, the non-fired covering 4 is overlaid so as to extend at least over the edge portion 31 of the non-fired thick film conductor layer 3 and the non-fired substrate 2 on the outer side of the edge portion 31. And, the covering 4 which covers the edge portion 31 of the thick film conductor layer 3 and which is bonded to the LTCC substrate 2 on the outer side of the edge portion 31, is finally formed.

In the firing step, for example, first, the non-fired laminate is heated to a temperature of from 500 to 600°C to carry out binder burn out of decomposing and removing the binder such as a resin, and then the laminate is heated to a temperature of about from 800 to 1,000°C. By this heating, the non-fired LTCC substrate 2 and the non-fired covering 4 are fired to form a LTCC substrate 2 and a covering 4, and at the same time, the non-fired thick film conductor layer 3 and the non-fired through hole conductors 6 are fired to form a thick film conductor layer 3 and through hole conductors 6.

In the plating step, a plated layer 5 is formed on the surface of the thick film conductor layer 3 thus obtained, specifically, on a portion not covered with the covering 4 on the surface of the thick film conductor layer 3, i.e. on the inside of the covering 4. The plated layer 5 is formed, for example, by nickel plating and then gold plating. The nickel plated layer is formed, for example, in a thickness of from 5 to 15 µm by electrolytic plating using a nickel sulfamate bath. Further, the gold plated layer is formed, for example, in a thickness of from 0.2 to 0.5 µm by electrolytic plating by using a gold potassium cyanide bath.

### EXAMPLES

Now, the present invention will be described in detail with reference to Examples.

### (Example 1)

As the substrate 1 for mounting an element, one shown in Figs. 1 and 2 was produced.

First, as a glass powder for a green sheet for substrate to be a LTCC substrate 2, glass materials were blended and mixed to achieve a glass having a glass composition comprising, as represented by mol% as calculated as the following oxides, 60.4 mol% of SiO₂. 15.6 mol% of B₂O₃, 6 mol% of Al₂O₃, 15 mol% of CaO, 1 mol% of K₂O and 2 mol% of Na₂O, this material mixture was put into a platinum crucible and melted at 1,600°C for 60 minutes, and glass in a molten state was cast and cooled. This glass was ground by an alumina ball mill for 40 hours to produce a glass powder. As a solvent at the time of grinding, ethyl alcohol was used.

40 mass% of the glass powder and 60 mass% of an alumina filler (manufactured by Showa Denko K.K., tradename: AL-45H) were blended and mixed to produce a glass ceramic composition. With 50 g of this glass ceramic composition, 15 g of an organic solvent (a mixture of toluene, xylene, 2-propanol and 2-butanol with a mass ratio of 4:2:2:1), 2.5 g of a plasticizer (di-2-ethylhexyl phthalate), 5 g of polyvinyl butyral (manufactured by Denki Kagaku Kogyo Kabushiki Kaisha, tradename: PVK#3000K) as a binder and 0.5 g of a dispersing agent (manufactured by BYK Japan K.K., tradename: BYK180) were blended and mixed to prepare a slurry.

This slurry was applied on a PET film by a doctor blade method and dried to produce a green sheet for substrate having a thickness after firing of 0.15 mm.

Further, an electrically conductive powder (manufactured by DAIKEN CHEMICAL CO., LTD., tradename: S400-2) containing silver as the main component and ethyl cellulose as a vehicle were blended in a mass ratio of 90:10, and dispersed in α-terpineol as a solvent so that the solid content became 87 mass%, and the dispersion was kneaded in a porcelain mortar for one hour and further dispersed three times by a triple roll to prepare a metal paste.

Through holes having a diameter of 0.3 mm were formed by a punch at portions on which through hole conductors 6 were to be formed on the green sheet for substrate, and filled with the metal paste by a screen printing method to form non-fired through hole conductors 6, and the metal paste was applied on the surface by a screen printing method to form a non-fired thick film conductor layer thereby to produce a non-fired LTCC substrate 2.

Further, in the same manner as the green sheet for substrate except that the thickness was changed, a green sheet for covering to be a covering 4 was produced. The green sheet for covering was cut in accordance with the shape of the mounting surface 2a of the non-fired LTCC substrate 2, and holes are formed by a punch on portions (excluding edge portions 31) to be located on the inside of the mounting surface 2a and above the non-fired thick film conductor layer 3, to produce a non-fired covering 4.

Further, the non-fired covering 4 was overlaid on a predetermined position on the mounting surface 2a of the non-fired LTCC substrate 2, and they are pressurized so that the non-fired covering 4 was closely attached to the non-fired LTCC substrate 2 to form a non-fired laminate. Then, binder burn out was carried out by holding the laminate at 550°C for 5 hours, and firing was carried out by holding the laminate at 870°C for 30 minutes to produce a LTCC substrate 2 on which the edge portion 31 of the thick film conductor layer 3 having a thickness of 10 µm and the mounting surface 2a on the outer side of the edge portion 31 were covered with the covering 4.

Then, on a portion not covered with the covering 4 on the surface of the thick film conductor layer 3, a nickel plated layer of 7 µm was formed by electrolytic plating by using a nickel sulfamate bath, and on its surface, a gold plated layer having a thickness of 0.3 µm was formed by electrolytic plating by using a gold potassium cyanide bath to form a plated layer 5.

In such a manner, a substrate 1 for mounting an element on which the edge portion 31 of the thick film conductor layer 3 and the mounting surface 2a on the outside thereof were covered with the covering 4 and the plated layer 5 was formed on a portion not covered with the covering 4 on the surface of the thick film conductor layer 3, was produced.

Of the covering 4, the region (W₁) was adjusted to be 0.05 mm, the region (W₂) at least 0.20 mm (the entire mounting surface 2a excluding the thick film conductor layer 3), and the height (H) 0.10 mm. The region (W₁) was made to be constant over the entire circumference of the thick film conductor layer 3, and the height (H) was made to be constant in the inside and outside direction of the thick film conductor layer 3 and constant over the entire circumference of the edge portion of the thick film conductor layer 3.

### (Example 2)

In production of the substrate 1 for mounting an element in Example 1, the green sheet for covering was cut into a ring form so as to cover only the vicinity of the edge portion 31 of the thick film conductor layer 3 and the outer side thereof to produce a non-fired covering 4, which was overlaid on the predetermined position of the mounting surface 2a of the non-fired LTCC substrate 2, and they were entirely pressurized so that the non-fired covering 4 was closely attached to the non-fired LTCC substrate 2 to obtain a non-fired laminate. Then, in the same manner as in Example 1, binder burn out, firing and plating were carried out to produce a substrate 1 for mounting an element having a ring-form covering 4. Of the covering 4, the region (W₁) was adjusted to be 0.03 mm, the region (W₂) 0.10 mm and the height (H) 0.02 mm.

### (Comparative Example 1)

A substrate for mounting an element was produced without forming a covering in production of the substrate for mounting an element in Example 1. That is, a non-fired substrate having a non-fired thick film conductor layer was produced in the same manner as in Example 1, and then binder burn out and firing were carried out without forming a non-fired covering to produce a LTCC substrate, and on the entire surface of the thick film conductor layer of the LTCC substrate, plating was carried out to produce a substrate for mounting an element.

Then, each of the substrates for mounting an element in Examples and Comparative Example was exposed for 100 hours in hydrogen sulfide test in accordance with JIS C60068-2-43, and sulfurization (blackening) of the plated layer 5, particularly the gold plated layer on the mounting surface 2a was observed by a microscope with a magnification of 20. The results are shown in Table 1. In Table 1, "⊚" in the column of blackening represents that no blackening observer, "○" represents that blackening slightly observed, and "x" represents that blackening definitely observed.

**[Table 1]**

| | Covering (mm) | | | Blackening |
|---|---|---|---|---|
| | Region (W₁) | Region (W₂) | Height (H) | |
| Example 1 | 0.05 | 0.20 | 0.10 | ⊚ |
| Example 2 | 0.03 | 0.10 | 0.02 | ○ |
| Comp. Ex. 1 | - | - | - | × |

As shown in Table 1, in the substrate 1 for mounting an element in each Example in which the covering 4 was formed, it was confirmed that peeling of the thick film conductor layer 3 from the LTCC substrate 2 was suppressed, and diffusion and sulfurization of silver from the thick film conductor layer 3 to the surface of the plated layer 5 was effectively suppressed. On the other hand, in the substrate for mounting an element in Comparative Example in which no covering was formed, as the thick film conductor layer was peeled from the LTCC substrate, it was confirmed that silver diffused to the surface of the plated layer and was sulfurized.

In the above Examples, the LTCC substrate 2 and the covering 4 were formed by a glass ceramic composition containing a glass powder and an alumina filler. The same effects as in the above Examples are obtained even in a case where a part of the alumina filler is replaced with a zirconia filler and a glass ceramic composition (a glass ceramic composition containing 38 mass% of a glass powder, 38 mass% of an alumina filler and 24 mass% of a zirconia filler (manufactured by DAIICHI KIGENSO KAGAKU KOGYO CO., LTD., tradename: HSY-3F-1) which is a mixture of an alumina filler with a zirconia filler, is used in the above Examples. Thus, combination of the glass powder and the ceramic filler in the glass ceramic is not limited to the above Examples and may suitably be changed.

### INDUSTRIAL APPLICABILITY

According to the present invention, by forming a covering made of a low temperature co-fired ceramic, so as to cover the edge portion of a thick film conductor layer and so as to be bonded to a low temperature co-fired ceramic substrate on the outer side of the edge portion, peeling of the thick film conductor layer from the low temperature co-fired ceramic substrate can be suppressed, and a substrate for mounting an element having good sulfurization resistance can be obtained.

The entire disclosure of Japanese Patent Application No. 2010-034717 filed on February 19, 2010 including specification, claims, drawings and summary is incorporated herein by reference in its entirety.

### REFERENCE SYMBOLS

- 1 :: Substrate for mounting element
- 2:: Low temperature co-fired ceramic substrate (LTCC substrate)
- 3:: Thick film conductor layer
- 4:: Covering
- 5:: Plated layer
- 6:: Through hole conductor

## Claims

1. A substrate for mounting an element, comprising:
a low temperature co-fired ceramic substrate,
a thick film conductor layer made of a metal composed mainly of silver, which is formed on the surface of the low temperature co-fired ceramic substrate,
a covering made of a low temperature co-fired ceramic, which covers the edge portion of the thick film conductor layer and which is bonded to the low temperature co-fired ceramic substrate on the outer side of the edge portion, and
a plated layer made of an electrically conductive metal, which is formed on the surface of the thick film conductor layer.

2. The substrate for mounting an element according to Claim 1, wherein of the covering, the portion which is formed on the thick film conductor layer, is formed in a region of from 0.05 to 0.2 mm on the inside of the edge of the thick film conductor layer, and of the covering, the portion which is formed on the low temperature co-fired ceramic substrate, is formed in a region of at least 0.2 mm on the outer side of the edge of the thick film conductor layer.

3. The substrate for mounting an element according to Claim 1, wherein of the covering, the portion which is formed on the thick film conductor layer, is formed in a region of from 0.03 to 0.2 mm on the inside of the edge of the thick film conductor layer, and of the covering, the portion which is formed on the low temperature co-fired ceramic substrate, is formed in a region of at least 0.2 mm on the outer side of the edge of the thick film conductor layer.

4. The substrate for mounting an element according to Claim 2, wherein the covering has a height of from 0.04 to 0.2 mm from the low temperature co-fired ceramic substrate, at its portion of up to 0.05 mm on the inside of the edge of the thick film conductor layer and at its portion of up to 0.2 mm on the outer side of the edge of the thick film conductor layer.

5. The substrate for mounting an element according to Claim 3, wherein the covering has a height of from 0.02 to 0.2 mm from the low temperature co-fired ceramic substrate, at its portion of up to 0.03 mm on the inside of the edge of the thick film conductor layer and at its portion of up to 0.2 mm on the outer side of the edge of the thick film conductor layer.

6. The substrate for mounting an element according to any one of Claims 1 to 5, wherein the covering is provided over the entire circumference of the edge portion of the thick film conductor layer.

7. The substrate for mounting an element according to any one of Claims 1 to 6, wherein the covering is made of the same material as the low temperature co-fired ceramic substrate.

8. The substrate for mounting an element according to any one of Claims 1 to 7, wherein the plated layer has a double-layered structure consisting of a nickel layer and a gold plated layer formed thereon.

9. A process for producing a substrate for mounting an element, comprising:
forming a non-fired thick film conductor layer made of a paste of a metal composed mainly of silver, on the surface of a non-fired substrate made of a glass ceramic composition containing a glass powder and a ceramic filler,
forming a non-fired covering made of a glass ceramic composition containing a glass powder and a ceramic filler, so as to extend over the edge portion of the non-fired thick film conductor layer and the non-fired substrate on the outside of the edge portion,
firing the non-fired substrate on which the non-fired thick film conductor layer and the non-fired covering are formed, to produce a substrate having a thick film conductor layer and a covering, and
forming a plated layer made of an electrically conductive metal on the surface of the thick film conductor layer.

10. The process for producing a substrate for mounting an element according to Claim 9, wherein the non-fired covering is a green sheet of a glass ceramic composition containing a glass powder and a ceramic filler.
